# EUROPEAN PATENT APPLICATION

(11) **EP 4 760 997 A1**
(43) Date of publication of application: **17.06.2026**
(21) Application number: 25213692.4
(22) Date of filing: 05.11.2025
(51) Int. Cl.: H01R 12/70, H01R 12/71, H01R 13/6594, H01R 43/00, H01R 24/60

(54) **CONNECTOR ASSEMBLY**

(30) Priority: 10.12.2024 JP 2024215353
(71) Applicant: Japan Aviation Electronics Industry, Ltd., Tokyo 150-0043 (JP)
(72) Inventor: HASHIGUCHI, Osamu, Tokyo (JP)
(74) Representative: INNOV-GROUP

(57) **Abstract**

A technique for easily attaching/detaching a connector to/from a substrate is provided. A connector assembly (500) according to the present disclosure includes: a frame (300) that can be disposed in a substrate (700) including a plurality of pads (702); and a connector (100) that is detachably connected to the frame (300). The connector (100) includes a shell (110) that holds a plurality of contacts (121A), and a connector contacting part. The frame (300) includes a frame contacting part. When the frame (300) is disposed in the substrate (700) and the connector (100) is attached to the frame (300), the plurality of contacts (121A) are pushed against the plurality of respective pads (702), elastically deformed, and electrically connected to the plurality of respective pads (702), and the connector contacting part receives a reaction force from the plurality of contacts (121A) and contacts the frame contacting part.

## Description

### BACKGROUND

The present disclosure relates to a connector assembly.

Patent Literature 1 discloses a connector mounted on a substrate. A connector 900 shown in Fig. 33 is one example of this connector.

The connector 900 includes a shell 911 and soldered parts 912. The soldered parts 912 are protruded from an outer surface of the shell 911. The soldered parts 912 are inserted into holes 951 of a circuit board 950 and soldered thereto. Thus, the connector 900 is fixed to the circuit board 950.

[Patent Literature 1] Japanese Unexamined Patent Application Publication No. 2012-182099

### SUMMARY

After the aforementioned connector is fixed to the substrate, in order to repair the connector, this connector may be replaced by another connector for repair. In such a case, it is required to easily attach the connector to the substrate or detach the connector from the substrate.

An object of the present disclosure is to provide a technique for easily attaching the connector to the substrate and detaching the connector from the substrate.

A connector assembly according to the present disclosure is a connector assembly including: a frame that can be disposed in a substrate including a plurality of pads; and a connector that is detachably connected to the frame, in which the connector includes a shell that holds a plurality of contacts, and a connector contacting part, the frame includes a frame contacting part, when the frame is disposed in the substrate and the connector is attached to the frame, the plurality of contacts are pushed against the plurality of respective pads, elastically deformed, and electrically connected to the plurality of respective pads, and the connector contacting part receives a reaction force from the plurality of contacts and contacts the frame contacting part.

According to the present disclosure, it is possible to easily attach a connector to a substrate and detach the connector from the substrate.

The above and other objects, features and advantages of the present disclosure will become more fully understood from the detailed description given hereinbelow and the accompanying drawings.

### BRIEF DESCRIPTION OF DRAWINGS

Fig. 1 is a perspective view of a connector mounted on a substrate (first embodiment);
Fig. 2 is a plan view of the connector mounted on the substrate (first embodiment);
Fig. 3 is a front view of the connector mounted on the substrate (first embodiment);
Fig. 4 is a bottom view of the connector mounted on the substrate (first embodiment);
Fig. 5 is a side view of the connector mounted on the substrate (first embodiment);
Fig. 6 is a cross-sectional view taken along the arrow VI-VI of Fig. 3 (first embodiment);
Fig. 7 is a cross-sectional view taken along the arrow VII-VII of Fig. 3 (first embodiment);
Fig. 8 is a cross-sectional view taken along the arrow VIII-VIII of Fig. 2 (first embodiment);
Fig. 9 is an exploded perspective view of a main part of a connector assembly (first embodiment);
Fig. 10 is an exploded perspective view of the connector (first embodiment);
Fig. 11 is a diagram showing a method for using the connector (first embodiment);
Fig. 12 is a diagram showing the method for using the connector (first embodiment);
Fig. 13 is a diagram showing the method for using the connector (first embodiment);
Fig. 14 is a cross-sectional view taken along the arrow XIV-XIV of Fig. 13 (first embodiment);
Fig. 15 is a cross-sectional view taken along the arrow XV-XV of Fig. 13 (first embodiment);
Fig. 16 is a diagram showing the method for using the connector (first embodiment);
Fig. 17 is a cross-sectional view taken along the arrow XVII-XVII of Fig. 16 (first embodiment);
Fig. 18 is a diagram showing a method for detaching the connector from the substrate (first embodiment);
Fig. 19 is a cross-sectional view taken along the arrow XIX-XIX of Fig. 18 (first embodiment);
Fig. 20 is a perspective view of a connector mounted on a substrate (second embodiment);
Fig. 21 is a perspective view showing the connector mounted on the substrate seen from another angle (second embodiment);
Fig. 22 is a front view of the connector mounted on the substrate (second embodiment);
Fig. 23 is a cross-sectional view taken along the arrow XXIII-XXIII of Fig. 22 (second embodiment);
Fig. 24 is a cross-sectional view taken along the arrow XXIV-XXIV of Fig. 22 (second embodiment);
Fig. 25 is an exploded perspective view of a main part of a connector assembly (second embodiment);
Fig. 26 is an exploded perspective view of the connector (second embodiment);
Fig. 27 is a diagram showing a method for using the connector (second embodiment);
Fig. 28 is a diagram showing the method for using the connector (second embodiment);
Fig. 29 is a diagram showing the method for using the connector (second embodiment);
Fig. 30 is a cross-sectional view taken along the arrow XXX-XXX of Fig. 29 (second embodiment);
Fig. 31 is a cross-sectional view taken along the arrow XXXI-XXXI of Fig. 29 (second embodiment);
Fig. 32 is a diagram showing the method for using the connector (second embodiment); and

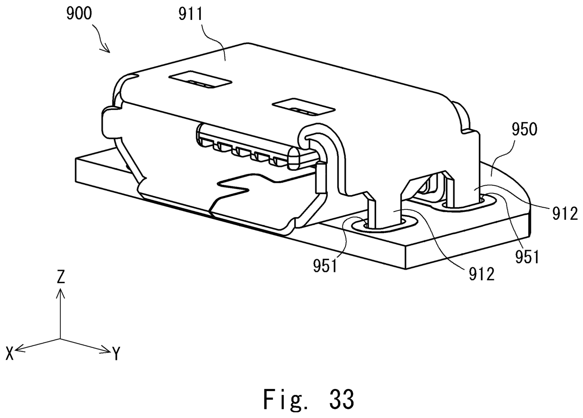

Fig. 33 is a diagram showing one example of a connector according to Patent Literature 1.

### DESCRIPTION OF EMBODIMENTS

Hereinafter, with reference to the drawings, specific embodiments to which the present disclosure is applied will be described in detail. However, the present disclosure is not limited to the following embodiments. Further, for the sake of clarification of the description, the following descriptions and drawings are simplified as appropriate.

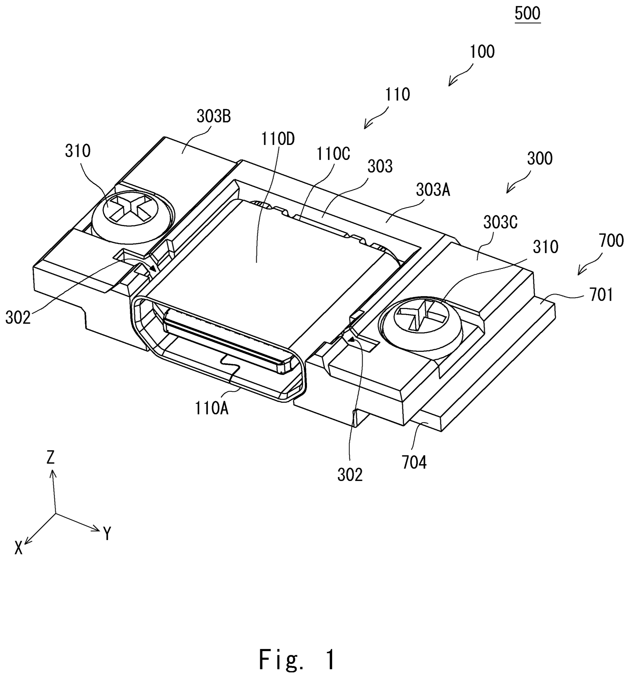

As a matter of course, the right-handed XYZ coordinates shown in Fig. 1 and other drawings are shown for convenience of describing the positional relationship of the components, and do not suggest any position when connector assemblies 500 and 600 and the like that will be described below are actually used. Normally, an X-axis direction is a mating direction in which connectors 100 and 200 that will be described below mate with opponent connectors that are not shown. Further, a Y-axis direction is a pitch direction, a Z-axis direction is a vertical direction, and an XY-plane is a horizontal plane, which is common among the drawings.

### <First Embodiment>

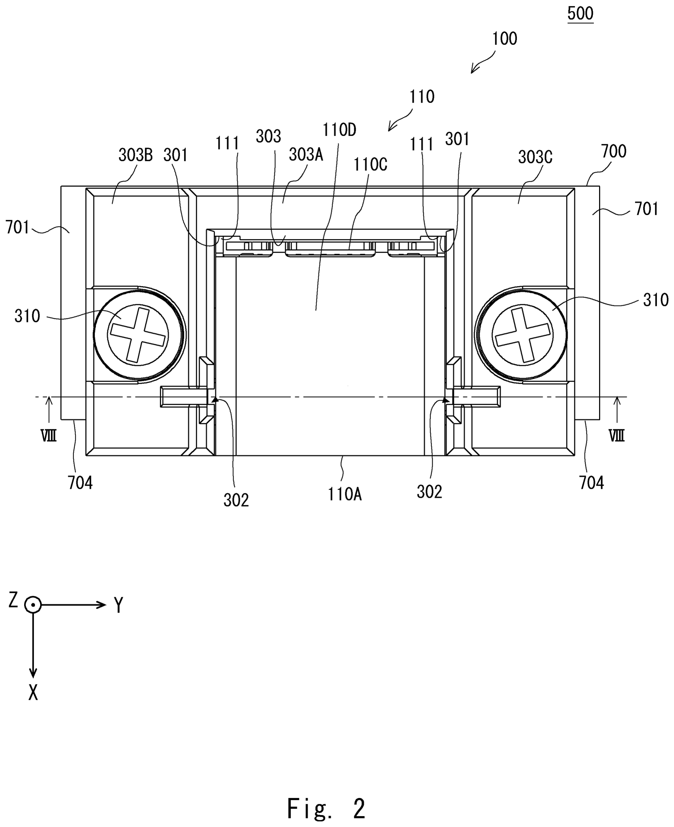

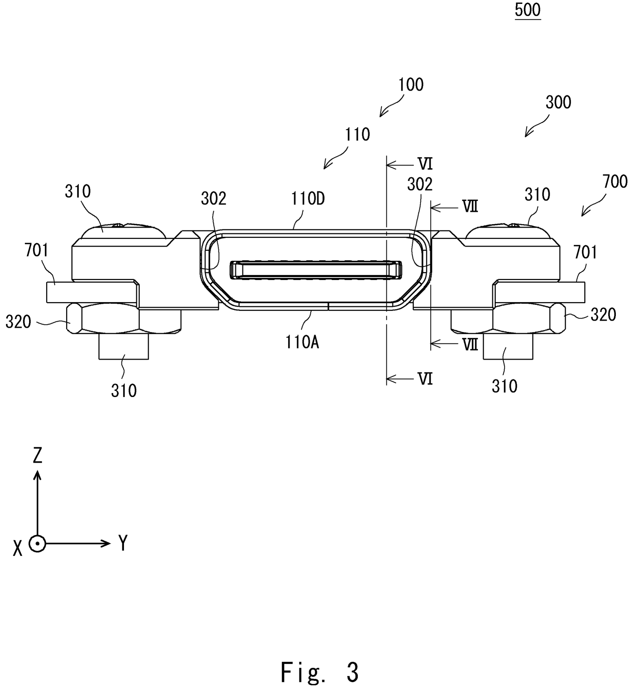

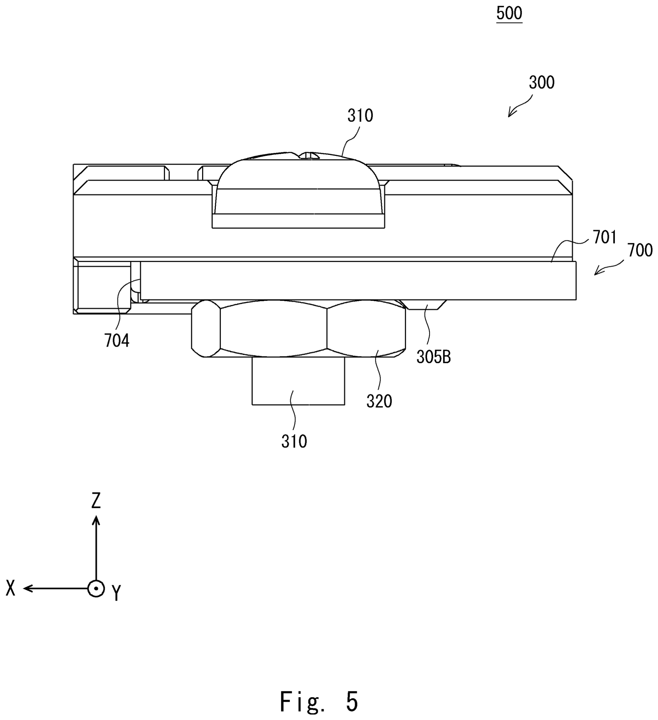

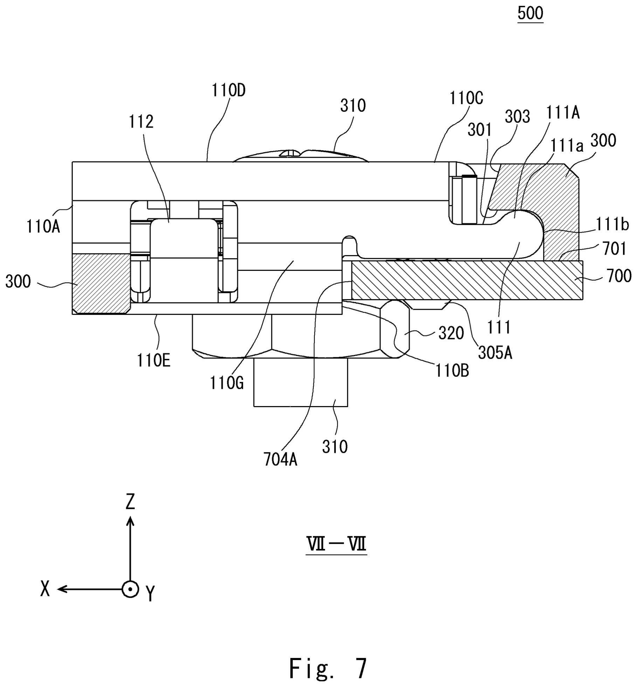

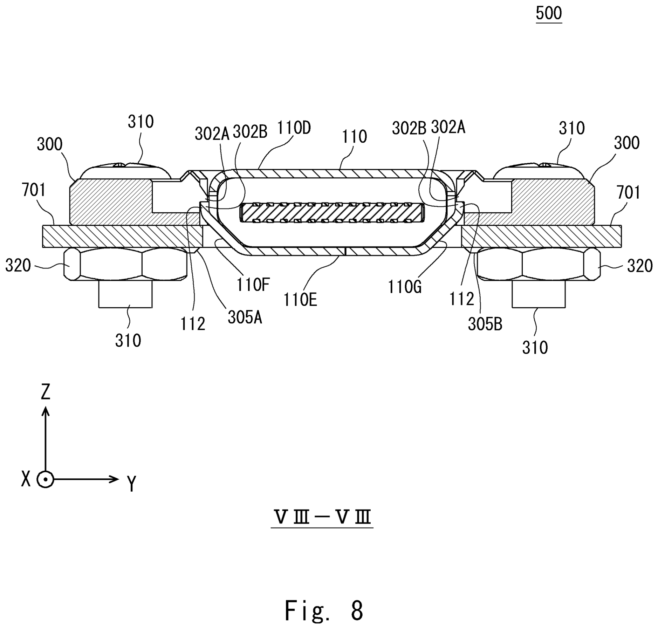

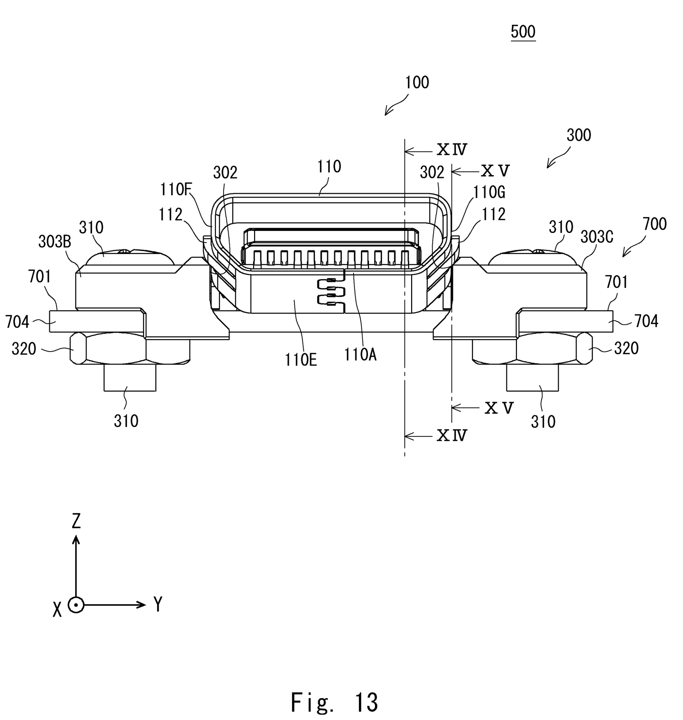

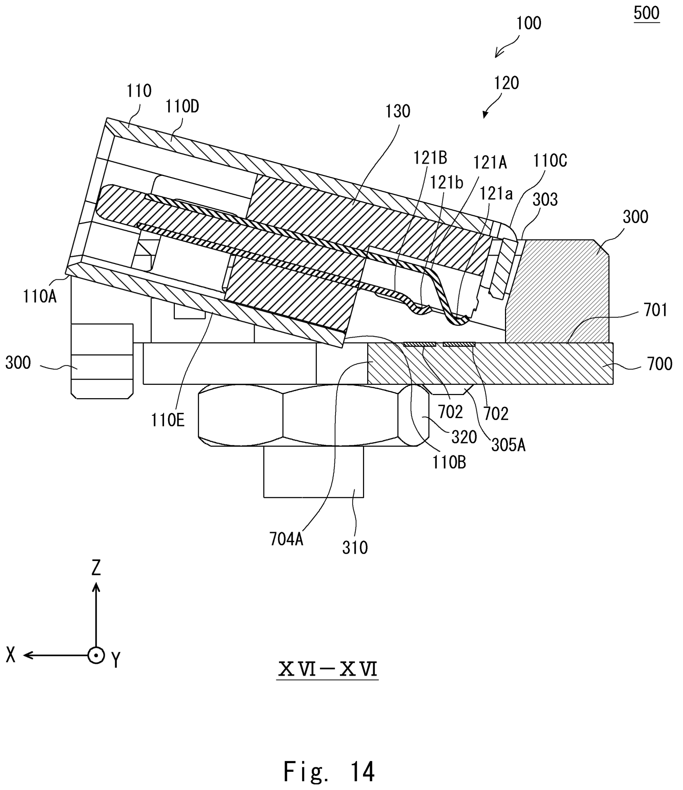

Hereinafter, with reference to Figs. 1 to 19, a first embodiment of the present disclosure will be described.

As shown in Figs. 1-10, a connector assembly 500 includes a connector 100 and a frame 300.

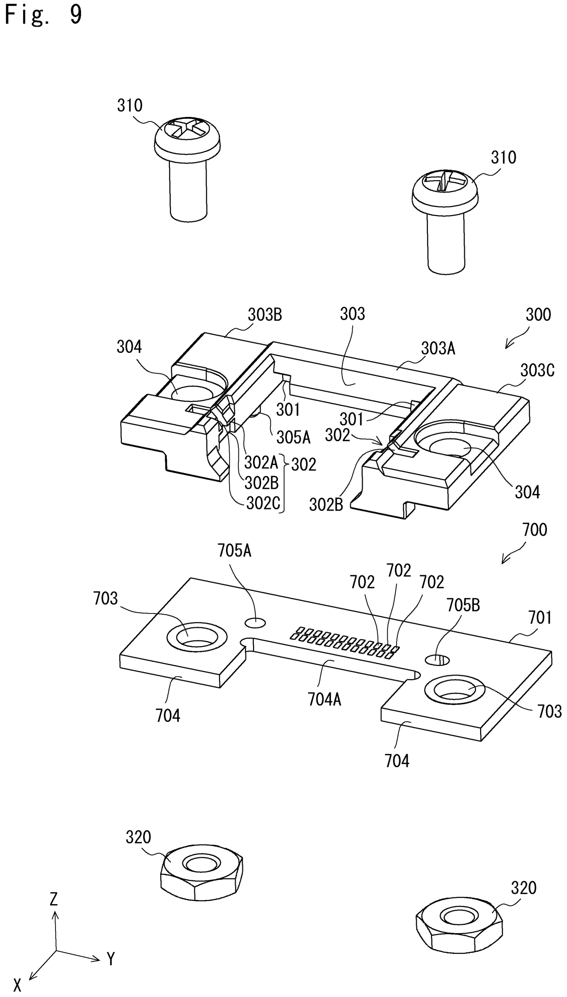

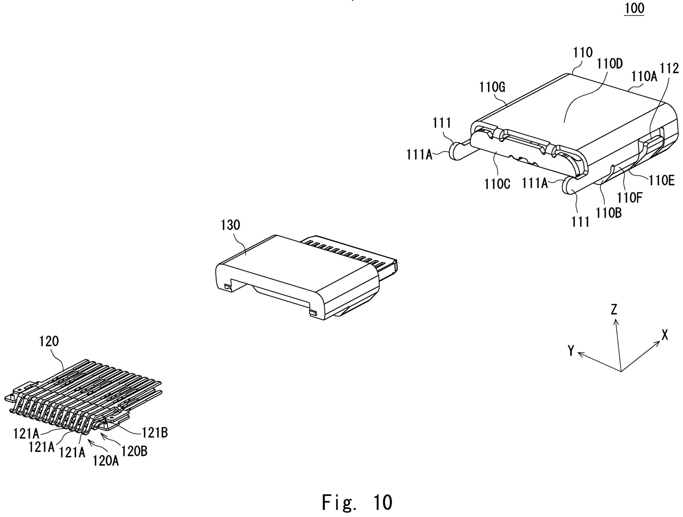

In the connector assembly 500, the connector 100 can be attached to a substrate 700 via the frame 300 and removed from the substrate 700. The connector 100 is mounted on a mounting surface 701 of the substrate 700 when the connector 100 is attached to the substrate 700 via the frame 300. The substrate 700 is, for example, a printed board such as a rigid substrate. As shown in Figs. 9 and 10, a plurality of pads 702 are disposed on the mounting surface 701 so as to be aligned in the pitch direction. In the first embodiment, the plurality of pads 702 are aligned in two lines. The substrate 700 may include a concave surface 704A that is further recessed on an end surface 704 when the mounting surface 701 is seen from above. The end surface 704 and the concave surface 704A may have shapes corresponding to the frame 300. Holes 703 and positioning holes 705A and 705B that penetrate through the substrate 700 are disposed on the mounting surface 701. In the first embodiment, two holes 703 are aligned in the pitch direction with a predetermined gap therebetween. The concave surface 704A is disposed between the two holes 703. Further, the positioning holes 705A and 705B are aligned in the pitch direction with a predetermined gap therebetween. The plurality of pads 702 are disposed between the positioning hole 705A and the positioning hole 705B. Further, the cross-sectional shape of the positioning hole 705A is a substantially circular, and the cross-sectional shape of the positioning hole 705B is a substantially track shape, specifically, oval, or a rectangular shape with rounded corners.

The connector 100 can mate with the opponent connector.

As shown in Fig. 10, the connector 100 includes a shell 110, a contact group 120, an insulator 130, protrusions 111, and lances 112. The connector 100 may include at least one of the protrusions 111 and lances 112.

The shell 110 holds the contact group 120. The shell 110 may be made of, for example, a resin material or a metal material. Specifically, the shell 110 accommodates the contact group 120 and the insulator 130. The contact group 120 and the insulator 130 may be integrated with each other. The contact group 120 is assembled in the insulator 130 and integrated therewith. The shell 110 is a substantially cylindrical body that surrounds the contact group 120 and the insulator 130.

The shell 110 includes a mating opening 110A, a substrate-side opening 110B, and a substrate-side end part 110C. The shell 110 includes an upper surface 110D, a bottom surface 110E, and side surfaces 110F and 110G. The cross-sectional shape of the shell 110 may be a substantially rectangular shape. In the shell 110, a corner part formed by an intersection of the upper surface 110D with the side surface 110F may be rounded. Likewise, a corner part formed by an intersection of the upper surface 110D with the side surface 110G, a corner part formed by an intersection of the bottom surface 110E with the side surface 110F, and a corner part formed by an intersection of the bottom surface 110E with the side surface 110G may be rounded. The mating opening 110A contacts the opponent connector when the connector 100 mates with the opponent connector.

The contact group 120 includes rows of contacts 120A and 120B that are aligned in the pitch direction (in this example, Y-axis direction). The row of contacts 120A is disposed above the row of contacts 120B. The row of contacts 120A includes a plurality of contacts 121A. The row of contacts 120B includes a plurality of contacts 121B. Each of the contacts 121A and 121B may be elastically deformable in a vertical direction (in this example, Z-axis direction). Each of the contacts 121A and 121B may be a rod-like body made of a conductive material. The contacts 121A and 121B respectively include contacting parts 121a and 121b that are pushed against the respective pads 702 when the connector 100 is attached to the substrate 700.

The insulator 130 is made of, for example, a resin material having insulating properties. The insulator 130 surrounds a part of the contact group 120. The insulator 130 insulates the contacts 121A and 121B. The contacts 121A and 121B of the contact group 120 extend out in the mating direction (in this example, X-axis direction) from the insulator 130.

The protrusions 111 are protruded from the shell 110. In the first embodiment, two protrusions 111 are protruded from one end and the other end of the substrate-side end part 110C in the mating direction. A distal end 111A of each of the protrusions 111 has an arc shape or a hemispherical shape protruding to the upper side.

The lances 112 are disposed in the shell 110. Specifically, the lances 112, which are disposed on the side surfaces 110F and 110G of the shell 110, are protruded obliquely upwardly. The lances 112 may be made of materials that can be elastically deformed. The lances 112 can be compressed and deformed in the pitch direction.

The shell 110, the protrusions 111, and the lances 112 may be integrated with each other. One plate may be pressed to integrate the shell 110, the protrusions 111, and the lances 112.

The frame 300 can be disposed in the substrate 700. As shown in Fig. 9, the frame 300 includes protrusion receiving parts 301, lance receiving parts 302, and a frame body 303.

The frame body 303 may extend on the mounting surface 701 in a substantially C shape, and may correspond to the shape of the connector 100. The frame body 303 includes a central part 303A and side parts 303B and 303C. The side parts 303B and 303C extend from both ends of the central part 303A in the same direction. The side parts 303B and 303C may be separated from each other by an amount equal to or greater than the width of the shell 110 in the pitch direction. The central part 303A and the side parts 303B and 303C may be disposed so as to surround the connector 100.

The protrusion receiving parts 301 may have a shape that is recessed in the central part 303A so that the protrusion receiving parts 301 can receive the protrusions 111. The two protrusion receiving parts 301 may be respectively disposed on the side of the side part 303B in the central part 303A and on the side of the side part 303C in the central part 303A.

The lance receiving parts 302 may each have a recessed shape so as to be able to receive the lance 112. The two lance receiving parts 302 may be respectively disposed in the side part 303B and the side part 303C. Each of the lance receiving parts 302 includes a protruding part 302A, a concave part 302B, and a groove 302C. The protruding parts 302A are protruded toward the inner side of the pitch direction. The concave parts 302B are disposed below the protruding parts 302A. The concave parts 302B are recessed in the outside of the pitch direction in such a way that the concave parts 302B can receive the lances 112. The grooves 302C, which are disposed in the protruding parts 302A, have a shape that is recessed so that tools can be inserted therein.

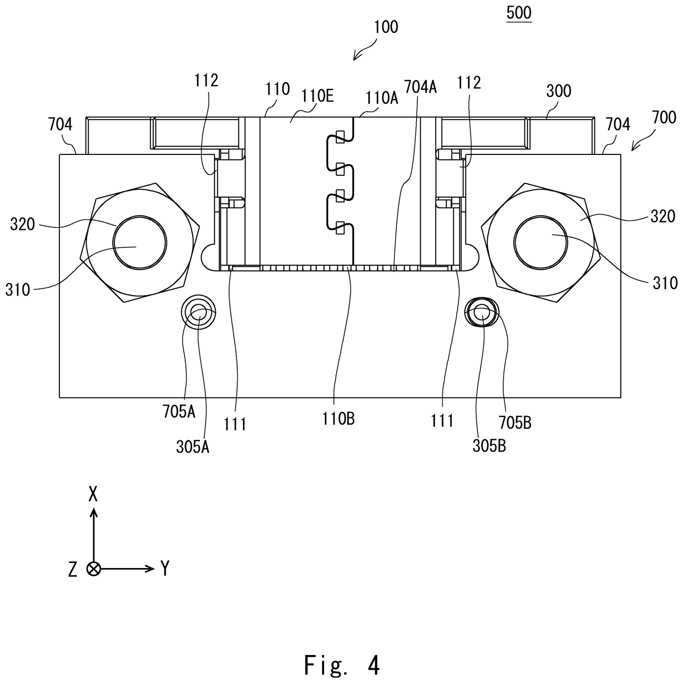

The frame 300 may further include holes 304. Bolts 310 are inserted into the holes 304 and the holes 703 to be fastened to nuts 320. Accordingly, the frame 300 can be disposed in the substrate 700. The frame 300 may further include positioning convex parts 305A and 305B. As shown in Figs. 4 to 9, the positioning convex part 305A and the positioning convex part 305B are respectively disposed in the side part 303B and the side part 303C. The positioning convex part 305A is a substantially columnar part that is protruded from the side part 303B toward the frame 300 (in this example, the negative direction of the Z-axis). The positioning convex part 305B is a substantially columnar part that is protruded from the side part 303C toward the frame 300.

### <Method>

Next, a method for attaching the connector 100 to the substrate 700 via the frame 300 will be described.

Prior to this method, the frame 300 is disposed in the substrate 700 in advance. Specifically, as shown in Figs. 9 to 11, the bolts 310 are inserted into the holes 304 of the frame 300 and the holes 703 of the substrate 700 to be fastened to the nuts 320. Further, the positioning convex part 305A and the positioning convex part 305B are respectively inserted into the positioning hole 705A and the positioning hole 705B. Accordingly, the position of the frame 300 with respect to the substrate 700 can be accurately determined.

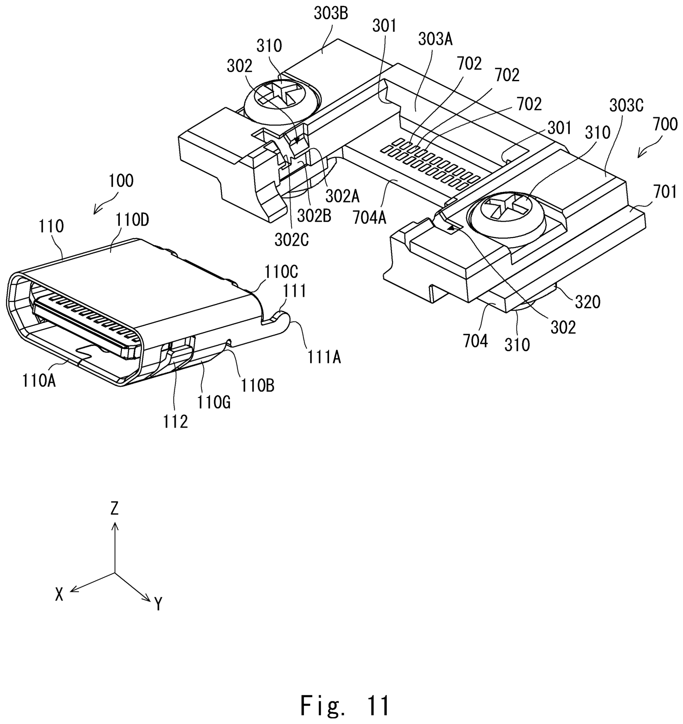

As shown in Fig. 11, the position of the connector 100 is inclined (Step ST1). Specifically, the position of the connector 100 is inclined in such a way that the protrusions 111 approach the mounting surface 701 of the substrate 700.

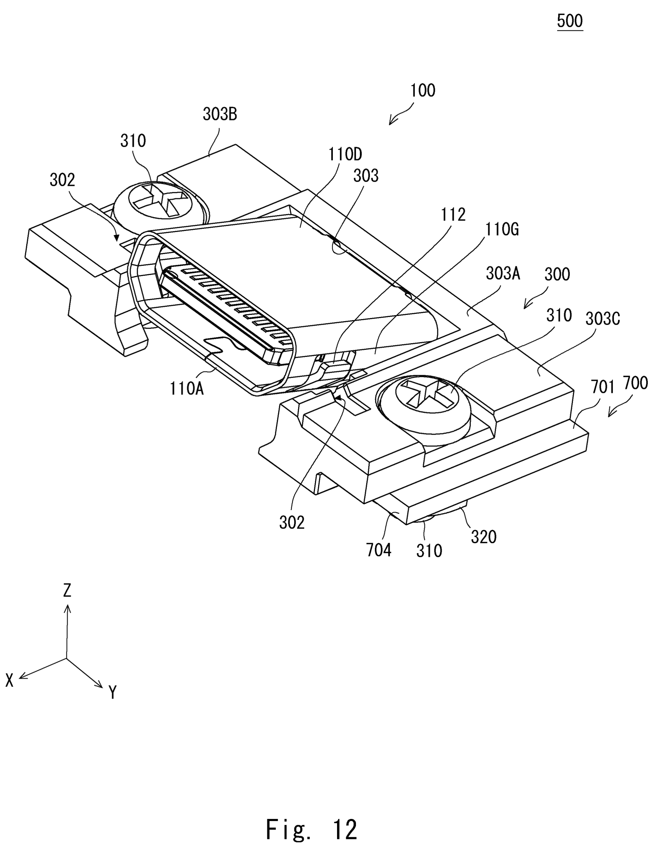

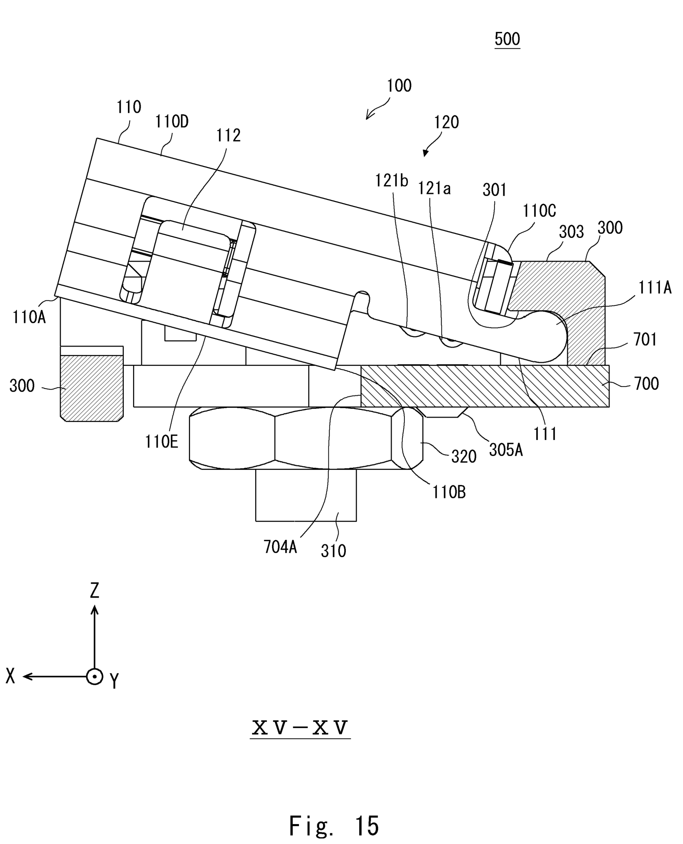

Next, as shown in Figs. 12 to 15, the connector 100 is moved toward the frame 300 while maintaining its inclined position (Step ST2). Further, as shown in Fig. 15, the protrusions 111 are inserted into the protrusion receiving parts 301.

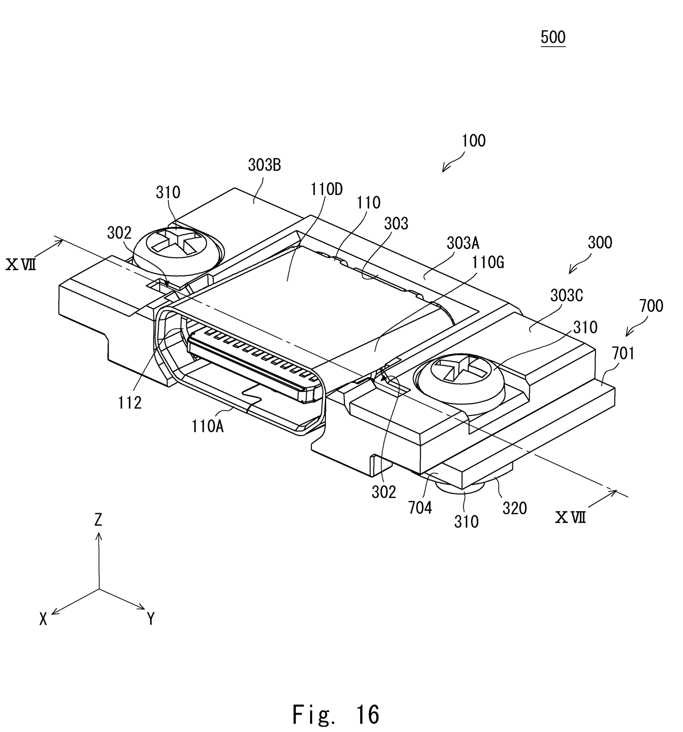

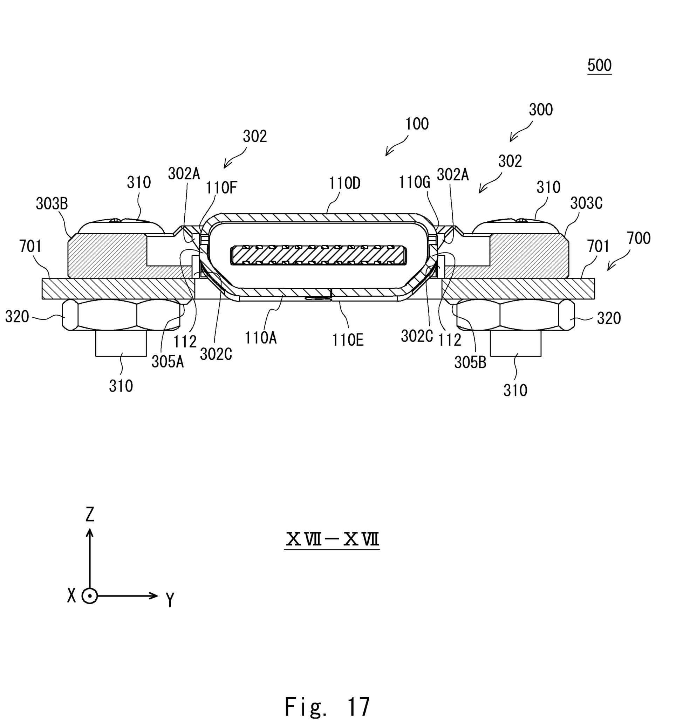

Last, while keeping the protrusions 111 in contact with the protrusion receiving parts 301, the shell 110 is rotated about the distal ends 111A of the protrusions 111 toward the substrate 700 (Step ST3). Further, as shown in Figs. 16 and 17, the lances 112 touch and contact the protruding parts 302A of the lance receiving parts 302, and are compressed and deformed in the pitch direction. When the shell 110 is further rotated, the lances 112 pass over the protruding parts 302A and are received in the concave parts 302B. The compression and deformation of the lances 112 are released, and the lances 112 are extended in the pitch direction. The width of the two lances 112 in the pitch direction may be made back to the original width.

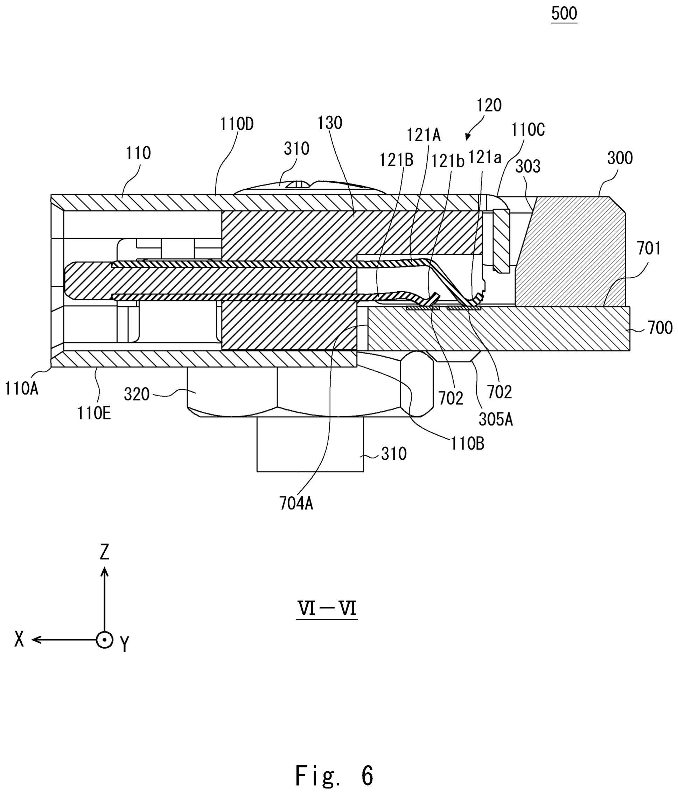

From the above description, as shown in Figs. 1 to 8, the connector 100 can be attached to the substrate 700 via the frame 300. As shown in Figs. 6 to 8, the plurality of contacts 121A and 121B are pushed against and contact the plurality of respective pads 702, and are electrically connected thereto. As described above, by disposing the frame 300 in the substrate 700, the position of the frame 300 with respect to the substrate 700 can be accurately determined. Therefore, each of the contacts 121A and 121B and each of the pads 702 can be accurately positioned, and they can be electrically connected to each other definitely. Further, since the plurality of contacts 121A and 121B are compressed and deformed in the vertical direction, the protrusions 111 and the lances 112 receive a reaction force from the plurality of contacts 121A and 121B via the insulator 130 and the shell 110. The protrusions 111 contact the protrusion receiving parts 301. Further, the lances 112 contact the lance receiving parts 302.

A user attaches the connector 100 to the substrate 700 via the frame 300 by gripping the mating opening 110A of the connector 100 or its vicinity. Here, each of the protrusions 111 functions as a fulcrum, each of the plurality of contacts 121A and 121B functions as a load, and the mating opening 110A or its vicinity functions as an effort. Because the principle of leverage works, a predetermined force can be applied to the mating opening 110A or its vicinity and a force greater than this predetermined force can be applied to the plurality of contacts 121A and 121B. Accordingly, the user can apply a small force to the mating opening 110A of the connector 100 or its vicinity, thereby attaching the connector 100 to the substrate 700 via the frame 300.

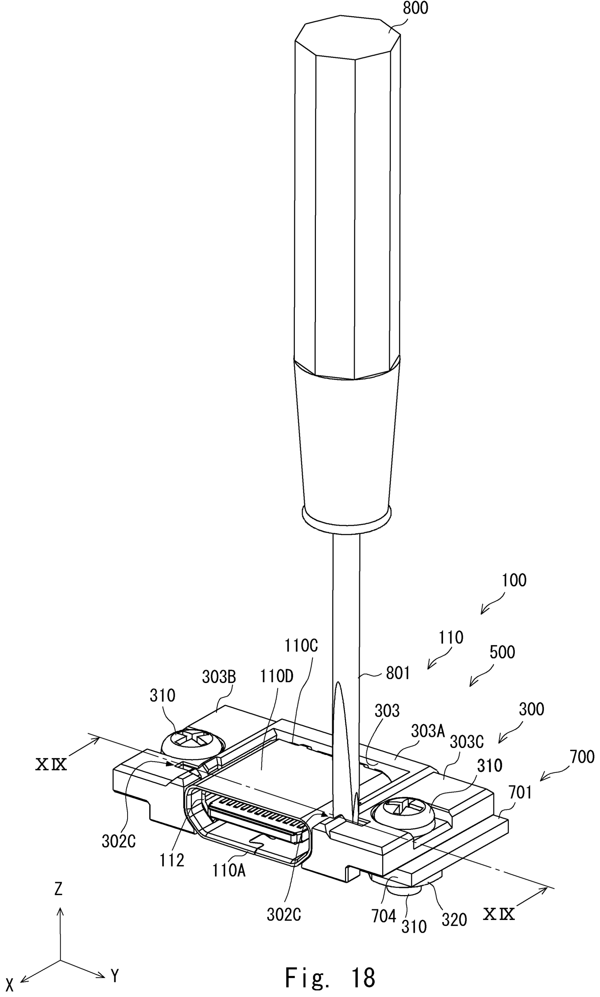

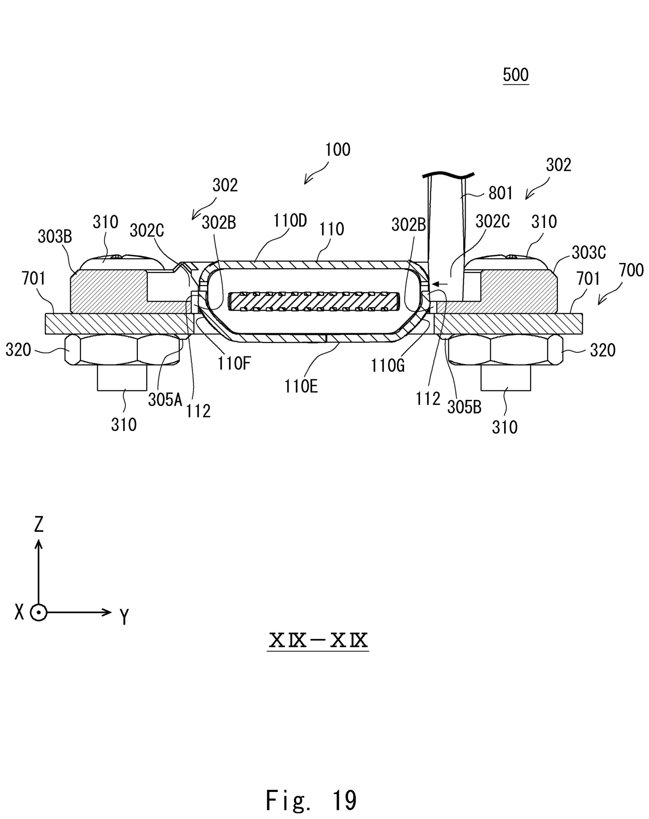

Regarding a method for detaching the connector 100 from the substrate 700, as shown in Figs. 18 and 19, first, a flat-head screwdriver 800 is inserted into each of the grooves 302C of the lance receiving parts 302. A distal end 801 of the flat-head screwdriver 800 touches and contacts each of the lances 112, and the lances 112 are compressed and deformed in the pitch direction. The flat-head screwdriver 800 may be the one that is widely used. Two flat-head screwdrivers 800 may be concurrently inserted into the two respective lance receiving parts 302. After that, each step may be performed in an order that is reverse to the one in the aforementioned method for attaching the connector 100 to the substrate 700. That is, while keeping the protrusions 111 in contact with the protrusion receiving parts 301, the shell 110 is rotated about the distal end 111A of the protrusion 111 in a direction in which it is separated away from the substrate 700. Next, the connector 100 is moved in a direction away from the frame 300 while maintaining its inclined position. Accordingly, the connector 100 can be detached from the substrate 700. When the frame 300 is kept to be attached to the substrate 700, the connector 100 can be attached to the substrate 700 via the frame 300 again.

The aforementioned method for attaching the connector 100 to the substrate 700 via the frame 300 and the method for detaching the connector 100 from the substrate 700 do not require work that requires much skill or special tools such as soldering and desoldering. That is, these methods can be performed by using widely available tools or user's hands. It is therefore possible to easily attach the connector 100 to the substrate 700 via the frame 300 and detach the connector 100 from the substrate 700.

### <Second Embodiment>

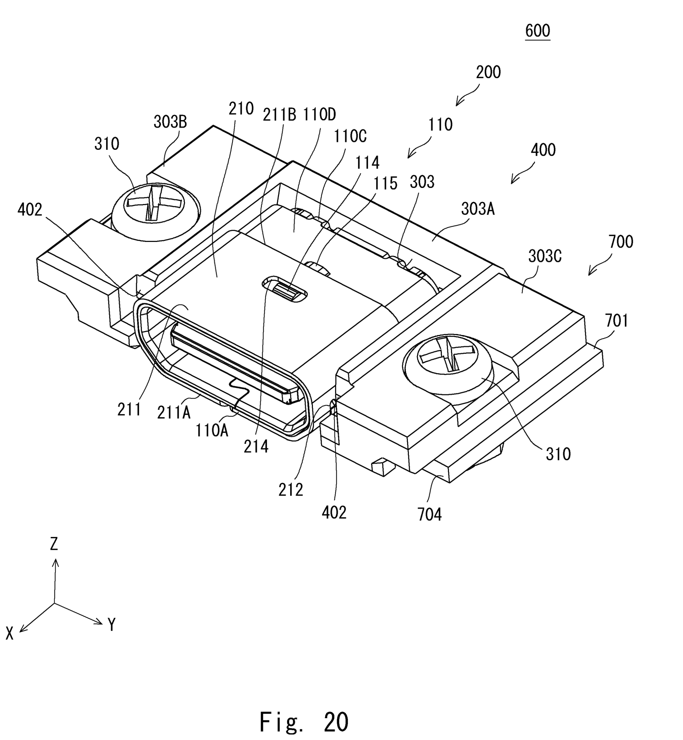

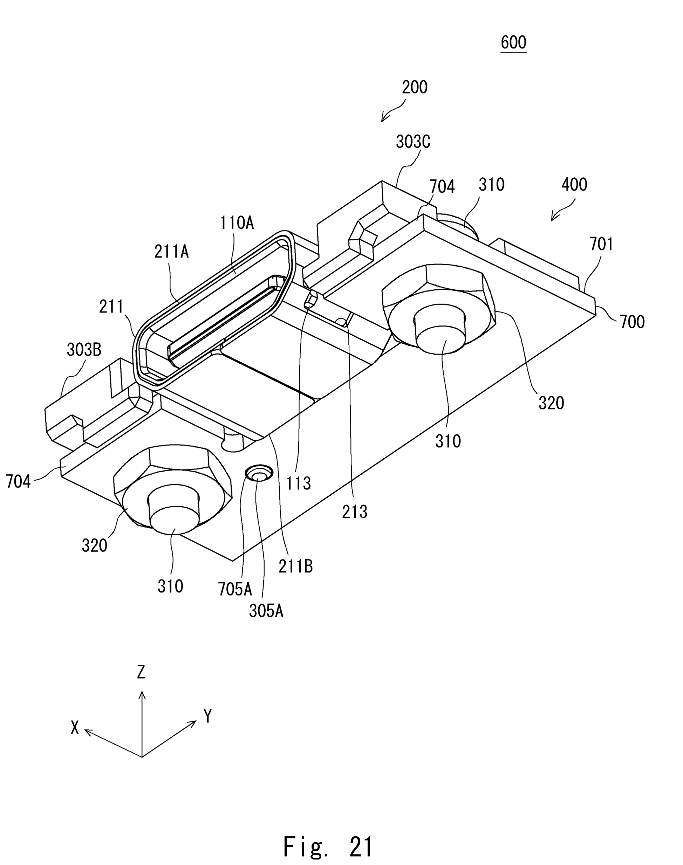

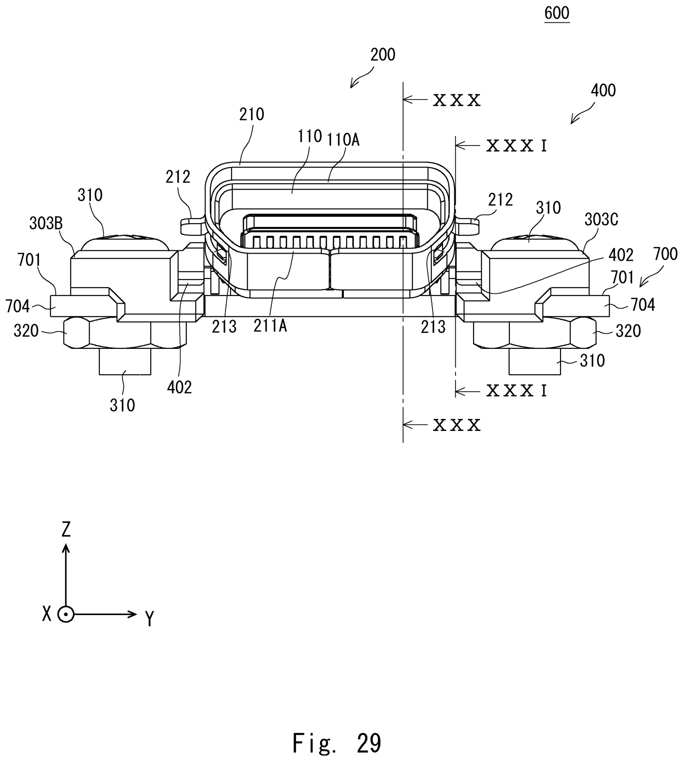

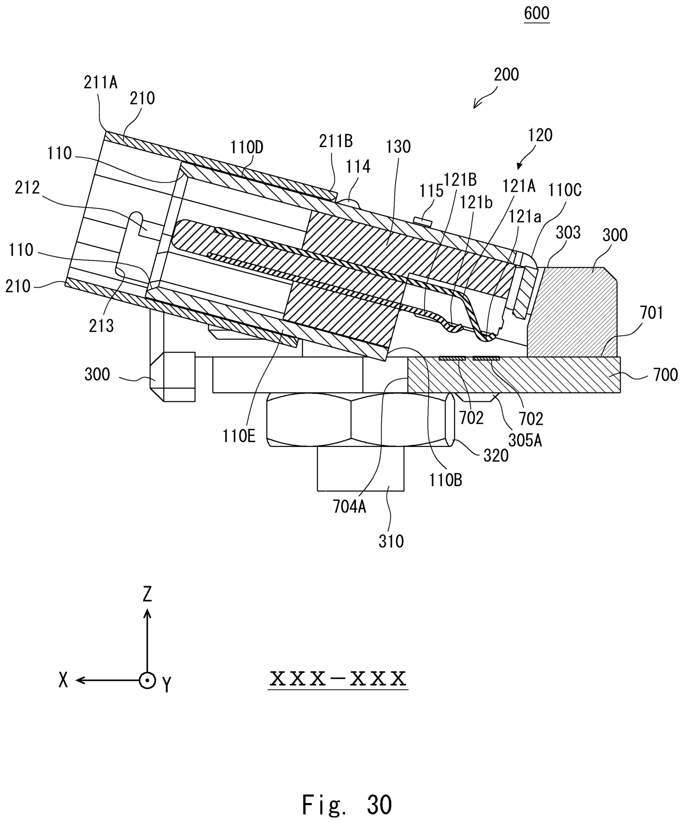

Next, with reference to Figs. 20 to 32, a second embodiment of the present disclosure will be described.

As shown in Figs. 20 to 26, a connector assembly 600 includes a connector 200 and a frame 400.

The connector 200 has a configuration the same as that of the connector 100 except that the connector 200 includes a slider 210.

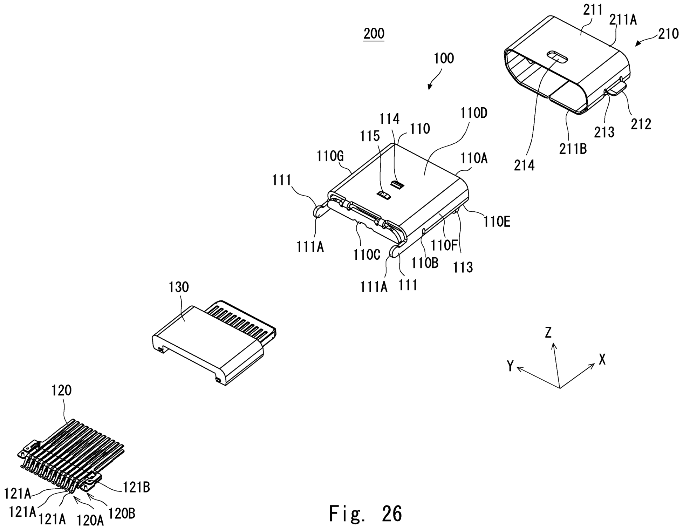

As shown in Fig. 26, the slider 210 is attached to a shell 110 in such a way the slider 210 can be slid in the mating direction (in this example, X-axis direction) with respect to the shell 110. The slider 210 includes a slider body 211 and wings 212. The slider body 211 may be a substantially cylindrical body that contains the shell 110. The slider body 211 includes a mating opening 211A and a substrate-side opening 211B. The wings 212 are plate-like parts that are protruded from the slider body 211 toward the outside of the pitch direction (in this example, Y-axis direction). The wings 212 extend in the mating direction. In the second embodiment, the wings 212 and holes 213 can be formed by performing slit processing on the slider body 211. The slider body 211 includes a hole 214. When the slider 210 is attached to the shell 110, the wings 212 may be respectively positioned on sides of side surfaces 110F and 110G in the slider body 211. Further, the hole 214 may be positioned on a side of an upper surface 110D in the slider body 211.

The shell 110 may include protruding parts 113, 114, and 115. The two protruding parts 113 may be disposed on the side surfaces 110F and 110G, respectively. The two protruding parts 113 are respectively protruded from the side surfaces 110F and 110G toward the outside of the pitch direction. The protruding parts 114 and 115 are protruded upward from the upper surface 110D. The protruding part 114 is disposed on the side of the mating opening 211A with respect to the protruding part 115 with a predetermined gap therebetween. The protruding part 114 has such a shape that it can be inserted into the hole 214 of the slider body 211. The protruding part 114 has an oblique surface.

The frame 400 has a configuration the same as that of the frame 300 except that the frame 400 includes grooves 402. Two grooves 402 are respectively disposed in a side part 303B and a side part 303C of a frame body 303 of the frame 400. The two grooves 402 may be respectively disposed in the side part 303B and the side part 303C in such a way that these grooves 402 are opposed to each other. The grooves 402 extend in the mating direction (in this example, X-axis direction). The grooves 402 may have such a shape that the wings 212 can be inserted into these grooves 402.

### <Method>

Next, a method for attaching the connector 200 to the substrate 700 via the frame 400 will be described.

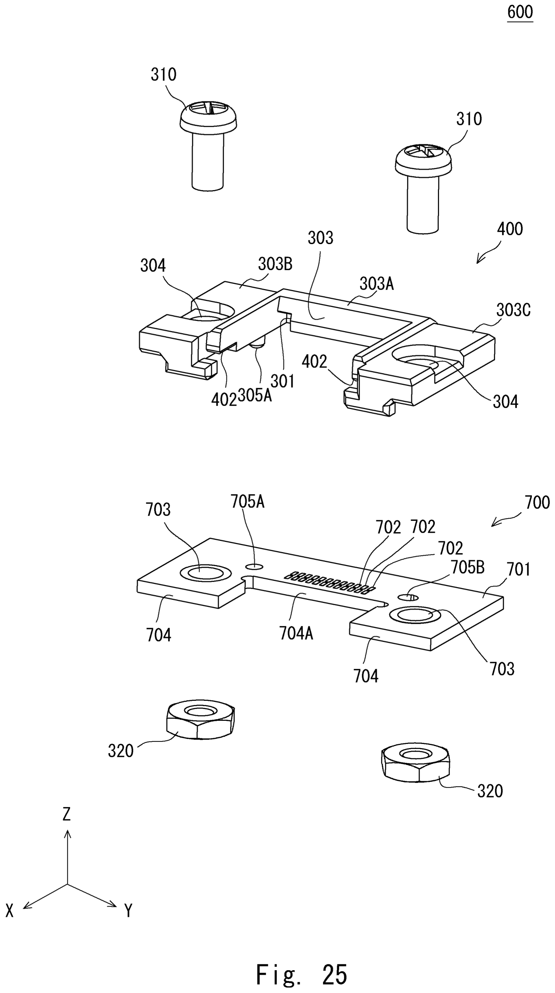

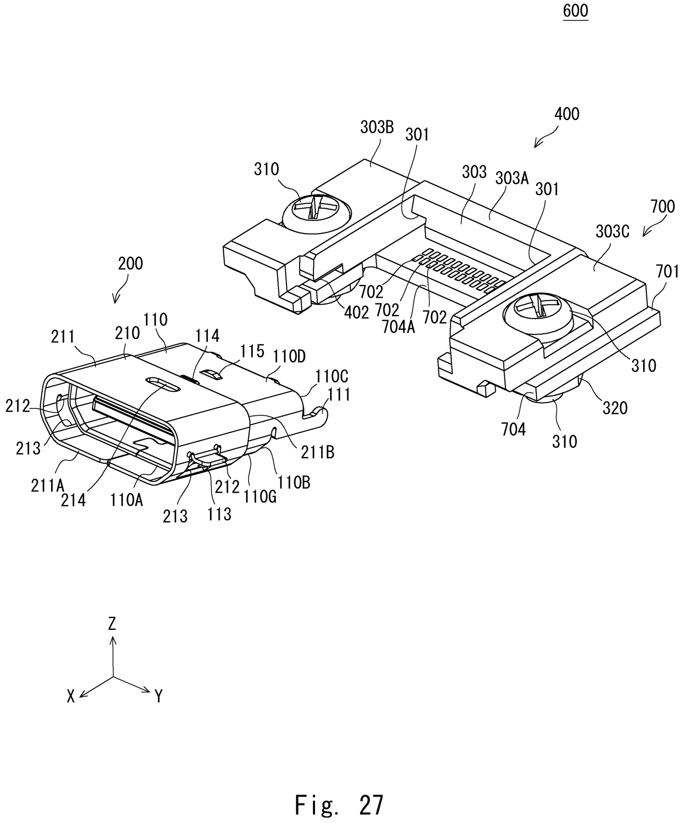

Prior to explaining this method, the frame 400 is disposed in the substrate 700 in advance. Specifically, as shown in Figs. 25 and 27, bolts 310 are inserted into holes 304 of the frame 400 and holes 703 of the substrate 700 to be fastened to nuts 320. Further, a positioning convex part 305A and a positioning convex part 305B of the frame 400 are respectively inserted into a positioning hole 705A and a positioning hole 705B. Accordingly, the position of the frame 400 with respect to the substrate 700 can be accurately determined. Further, the slider 210 is moved from a substrate-side opening 110B toward a mating opening 110A of the shell 110 in advance. The slider 210 may be moved until the protruding part 114 is positioned on the side of a substrate-side end part 110C (in this example, the negative direction of the X-axis) with respect to the substrate-side opening 211B of the slider body 211. When the slider 210 is further moved on the side of the opponent connector (in this example, the positive direction of the X-axis) in a case where the mating of the connector 200 and the opponent connector is released, the protruding parts 113 interfere with the substrate-side opening 211B, and further movement of the slider 210 is prevented or reduced, which prevents the slider 210 from departing from the shell 110. That is, the slider 210 is kept to be attached to the shell 110. At this time, the protruding part 114 is positioned on the side of the substrate-side end part 110C (in this example, the negative direction of the X-axis) with respect to the substrate-side opening 211B. Since the protruding part 114 has an oblique surface, when the slider 210 is pushed toward the opponent connector (in this example, the positive direction of the X-axis), the substrate-side opening 211B passes over the protruding part 114. However, further movement of the slider 210 is not easy. The slider 210 can maintain the state in which it is attached to the shell 110. In other words, by simply pushing the slider 210 toward the opponent connector by a normal force, the slider 210 can be moved to an appropriate position.

As shown in Fig. 27, like in the aforementioned Step ST1, the position of the connector 200 is inclined (Step ST21). Specifically, the position of the connector 100 is inclined in such a way that protrusions 111 approach a mounting surface 701 of the substrate 700.

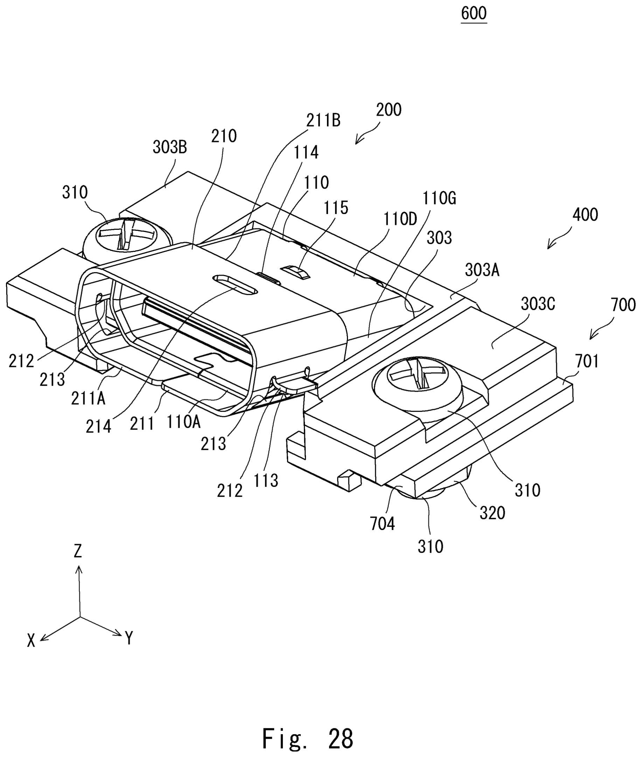

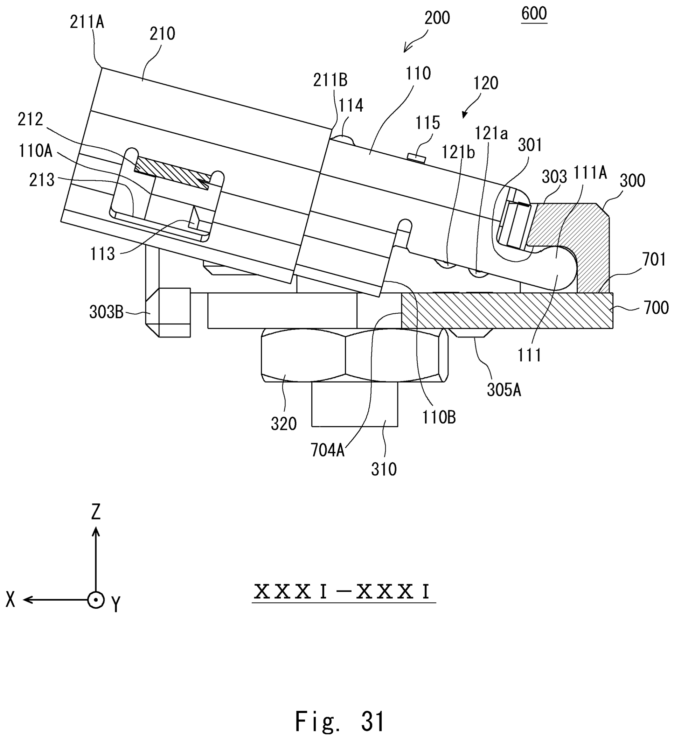

Next, as shown in Figs. 28 to 31, like in the aforementioned Step ST2, the connector 200 is moved toward the frame 400 while maintaining its inclined position (Step ST22). Further, as shown in Fig. 31, the protrusions 111 are inserted into protrusion receiving parts 301.

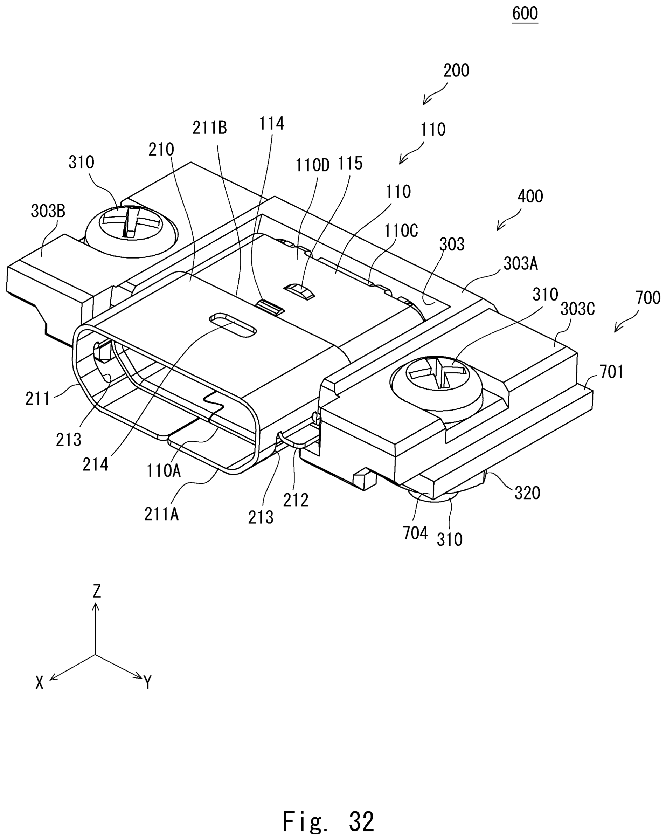

Next, while keeping the protrusions 111 in contact with the protrusion receiving parts 301, the shell 110 is rotated about distal ends 111A of the protrusions 111 toward the substrate 700 (Step ST23). As shown in Fig. 32, the wings 212 are disposed in the vicinity of the grooves 402.

Last, as shown in Figs. 20 to 24, the wings 212 are inserted into the grooves 402 (Step ST24). Specifically, the slider 210 is slid toward a central part 303A of the frame body 303. Then, the protruding part 114 is accommodated in the hole 214 of the slider body 211. Accordingly, vibrations or sounds are generated and transmitted to a user, which can give the user a clicking sensation. Therefore, the user can slide the slider 210 while feeling the clicking sensation. When the slider 210 is further slid, the substrate-side opening 211B of the slider body 211 touches and contacts the protruding part 115. Accordingly, the slide of the slider 210 can be controlled. It is also possible to prevent or reduce the wings 212 from colliding with the grooves 402 and from being damaged.

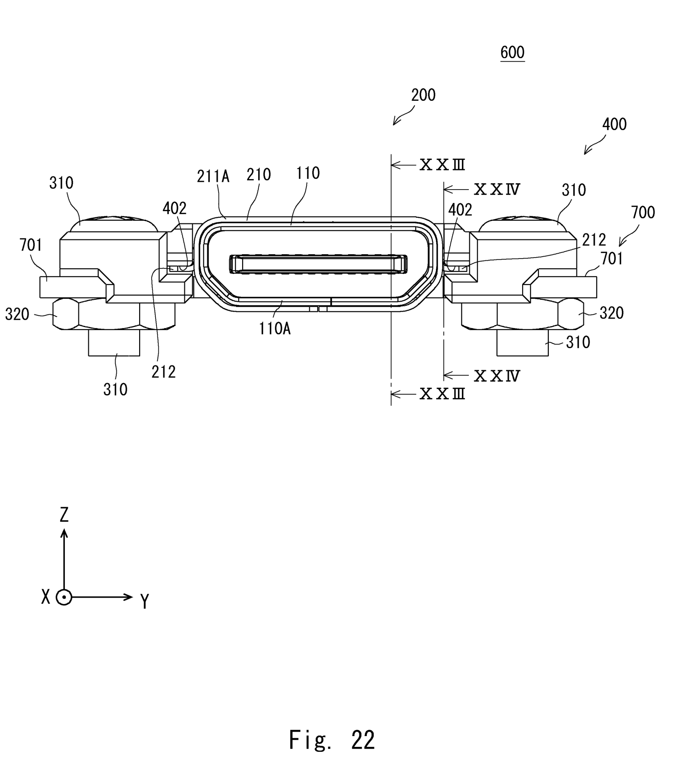

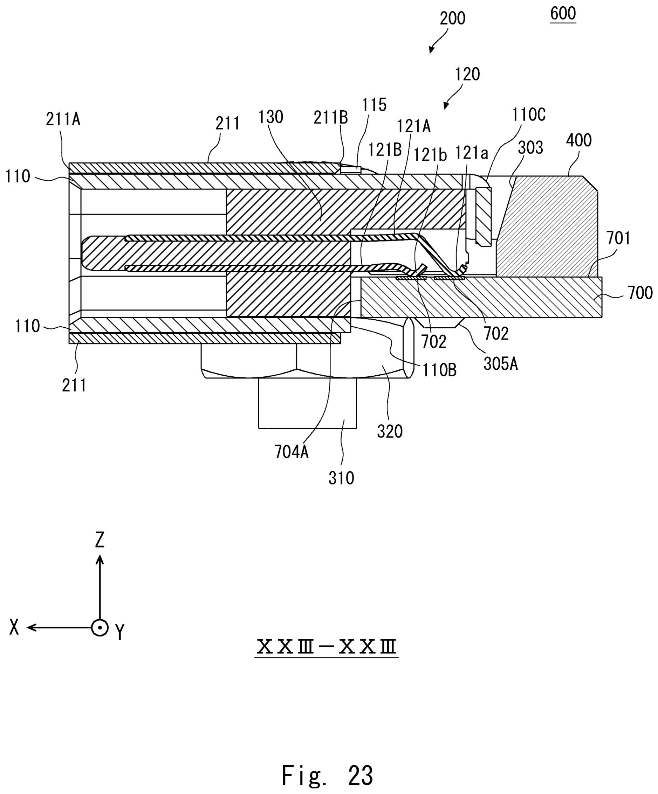

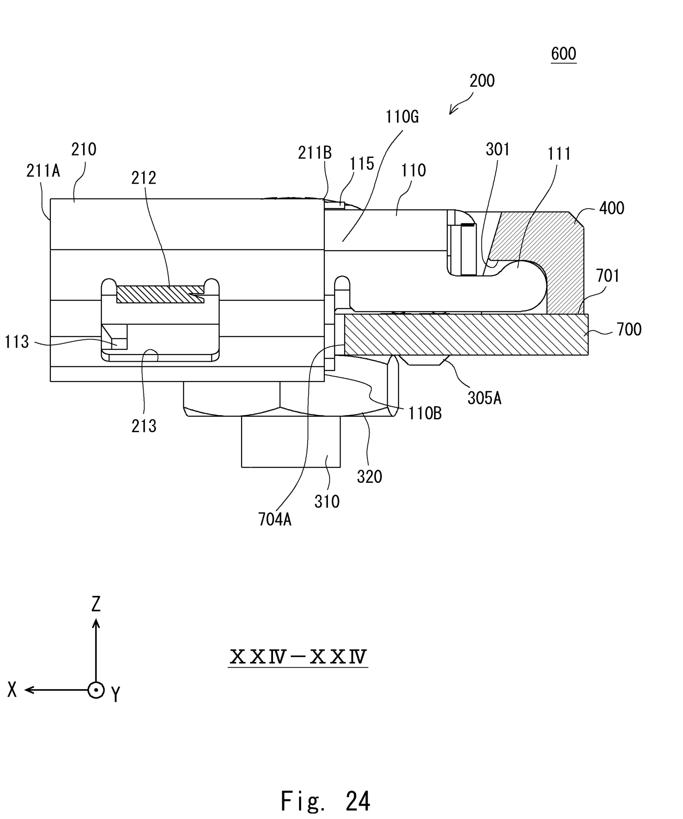

As described above, the connector 200 can be attached to the substrate 700 via the frame 400. As shown in Fig. 23, a plurality of contacts 121A and 121B are respectively pushed against and contact a plurality of pads 702, and electrically connected thereto. As described above, by disposing the frame 400 in the substrate 700, the position of the frame 400 with respect to the substrate 700 is accurately determined. Therefore, each of the contacts 121A and 121B and each of the pads 702 can be accurately positioned, and they can be electrically connected to each other definitely. Further, since the plurality of contacts 121A and 121B are compressed and deformed in the vertical direction, the protrusions 111 and the wings 212 receive a reaction force from the plurality of contacts 121A and 121B via an insulator 130 and the shell 110. As shown in Fig. 24, the protrusions 111 contact the protrusion receiving parts 301. As shown in Figs. 20 and 22, the wings 212 contact the grooves 402.

Regarding a method for detaching the connector 200 from the substrate 700, each step may be performed in an order that is reverse to the one in the aforementioned method for attaching the connector 200 to the substrate 700. That is, the wings 212 are removed from the grooves 402. Next, the shell 110 is rotated about the distal ends 111A of the protrusions 111 in a direction in which the shell 110 is separated away from the substrate 700 while keeping the protrusions 111 in contact with the protrusion receiving parts 301. Last, the connector 200 is moved in a direction away from the frame 400 while maintaining its inclined position. Accordingly, the connector 200 can be detached from the substrate 700. When the frame 400 is kept to be disposed in the substrate 700, the connector 200 can be attached to the substrate 700 via the frame 400 again.

The aforementioned method for attaching the connector 200 to the substrate 700 via the frame 400 and the method for detaching the connector 200 from the substrate 700 do not require work that requires much skill or special tools such as soldering and desoldering. That is, these methods can be performed by using widely available tools or user's hands. Therefore, the connector 200 can be easily attached to the substrate 700 via the frame 400 and detached from the substrate 700.

Note that the present disclosure is not limited to the aforementioned embodiments, and may be changed as appropriate without departing from the spirit of the present disclosure. For example, while the substrate 700 having the concave surface 704A has been used in the first and second embodiments, a substrate having another shape, such as a substrate having a flat end surface with no concave surface may instead be used.

The first and second embodiments can be combined as desirable by one of ordinary skill in the art.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A connector assembly (500, 600) comprising:
a frame (300, 400) that can be disposed in a substrate (700) including a plurality of pads (702); and
a connector (100, 200) that is detachably connected to the frame (300, 400), wherein
the connector (100, 200) includes a shell (110) that holds a plurality of contacts (121A, 121B), and a connector contacting part,
the frame (300, 400) includes a frame contacting part,
when the frame (300, 400) is disposed in the substrate (700) and the connector (100, 200) is attached to the frame (300, 400),
the plurality of contacts (121A, 121B) are pushed against the plurality of respective pads (702), elastically deformed, and electrically connected to the plurality of respective pads (702), and
the connector contacting part receives a reaction force from the plurality of contacts (121A, 121B) and contacts the frame contacting part.

2. The connector assembly (500, 600) according to claim 1, wherein
the connector contacting part includes a protrusion (111) protruded from the shell (110),
the frame contacting part includes a protrusion receiving part (301) capable of contacting the protrusion (111), and
when the frame (300, 400) is disposed in the substrate (700),
when the protrusion (111) contacts the protrusion receiving part (301) and the shell (110) is rotated about a distal end (111A) of the protrusion (111), the connector (100, 200) is attached to the frame (300, 400).

3. The connector assembly (500) according to claim 1 or 2, wherein
the connector contacting part includes an elastically deformable lance (112) that is disposed in the shell (110),
the frame (300) includes a lance receiving part (302) capable of contacting the lance (112), and
when the frame (300) is disposed in the substrate (700),
the lance (112) contacts the lance receiving part (302), is elastically deformed, and is received in the lance receiving part (302), whereby the connector (100) is attached to the frame (300).

4. The connector assembly (600) according to claim 1 or 2, wherein
the connector contacting part includes a slider (210) capable of being slid relative to the shell (110),
the slider (210) includes a slider body (211) and a wing (212) protruded from the slider body (211),
the frame (400) includes a groove (402), and
when the frame (400) is disposed in the substrate (700),
the slider (210) is slid, the wing (212) is inserted into the groove (402), and the connector (200) is attached to the frame (400).

5. The connector assembly (500, 600) according to any one of claims 1 to 4, wherein
the frame (300, 400) includes a positioning convex part (305A, 305B), and
when the frame (300, 400) is disposed in the substrate (700), the convex part (305A, 305B) is inserted into a positioning hole (705A, 705B) of the substrate (700).
